# EUROPEAN PATENT SPECIFICATION

(11) **EP 2 240 345 B1**
(45) Date of publication and mention of the grant of the patent: **18.09.2013**
(21) Application number: 08858812.4
(22) Date of filing: 18.09.2008
(51) Int. Cl.: B60Q 1/26, B60Q 1/00, G09F 13/02, G02B 6/00, H05K 5/06, H05K 3/28, B60R 13/10

(54) **LIGHT FOR VEHICLES**
LICHT FÜR FAHRZEUGE
LAMPE POUR VÉHICULE

(30) Priority: 12.12.2007 US 13097 P; 19.03.2008 US 51512
(43) Date of publication of application: 20.10.2010
(73) Proprietor: Innotec, Corp., Zeeland, MI 49464 (US)
(72) Inventor: FLEISCHMANN, Eric L., Holland Michigan 49423 (US); DEVRIES, Nick J., Holland Michigan 49424 (US); VEENSTRA, Thomas J., Zeeland Michigan 49464 (US); JUDGE, Michael K., Livonia Michigan 48150 (US)
(74) Representative: Müller Schupfner & Partner
(86) International application number: PCT/US2008/076859
(87) International publication number: WO 2009/075924

(56) References cited:
- WO-A1-2007/036207
- DE-A1-102005 048 497
- GB-A- 2 431 764
- TW-A- 200 702 591
- US-A- 5 848 837
- US-A1- 2002 131 261
- US-A1- 2005 007 759
- US-A1- 2005 213 351
- US-A1- 2008 062 711
- US-B2- 6 419 306
- US-B2- 6 971 758
- US-B2- 7 140 751
- US-B2- 7 712 933

## Description

### BACKGROUND OF THE INVENTION

Various types of illuminated doorsill plates have been developed. Examples of known arrangements are disclosed in U.S. Patent Nos. 5,641,221, 6,244,734, 6,419,306, 6,889,456, 6,971,758, 6,604,834, 4,965,950, and 5,228,223

U.S. Patent No. 5,641,221 to Schindele et al. discloses a door entrance strip of a vehicle including a wall part with openings forming writing or symbols. A luminous foil is mounted on the covered side of the wall part, and is visible through the openings.

Hulse U.S. Patent No. 6,244,734 discloses an illuminated step-up for a vehicle that includes a plate mounted on the doorsill of a vehicle. An optical wave guide is formed from a solid piece of material, and is positioned to release light through a slot that extends along the step-up plate.

Sano et al. U.S. Patent No. 6,419,306 discloses an illuminated plate for a car including a light guide plate, and a cover that is provided with at least one light transmitting window. A light reflecting layer is formed on a rear surface of the light guide plate.

Shibata et al. U.S. Patent No. 6,889,456 discloses an LED light source that is received in a groove portion in a light guide plate. The groove portion is covered with a base member, and the circumferential edge of the base member is bonded to the light guide plate. Concave or convex portions having desired shapes are provided in a surface opposite to a light emission observable surface of the light guide plate so as to form character portions.

Inui et al. U.S. Patent No. 6,971,758 discloses an illumination device including an LED that is opposite to a side surface of a flat light guide member and a light shield surface for shielding light from the LED and emitting light toward the back side of the guide member.

Kalana U.S. Patent No. 6,604,834 discloses an illuminator device including an electroluminescent panel sealed in a transparent or translucent material. The electroluminescent panel is seated on a base, and is covered by an enclosure top.

Yamada U.S. Patent No. 4,965,950 discloses a display device including a light conducting member that is arranged on a rear surface of a display panel held on a case. A pair of light incident portions are formed at the right and left ends, and a pair of light sources are mounted in the light incident portions. A number of stipples are formed in a rear surface having a greater concentration towards the middle from the right and left ends.

Lan U.S. Patent No. 5,228,223 discloses a license plate for a motor cycle including a main body connected by two light-piercing boards. A white ground plate is damped between the light-piercing boards, and an opaque, blank vacant number plate is connected to the main body. A transparent waterproof hood encloses them all, and a PC board which includes a plurality of small bulbs on it is connected in a seat body for the main body.

WO 2007/036207 relates to an illumination unit comprising a luminescence diode chip mounted on a chip carrier and an optical waveguide, which is assembled from at least two separate parts, wherein the luminescence diode chip is being encapsulated by one of the parts of the optical waveguide.

US-2005/0213351 relates to a light-guiding structure, in which an LED is used as a light source to project light source at the two ends of an elongated thin light-guiding plate.

US-2002/0131261 A1 relates to an illumination device, wherein an LED is opposite to a side surface of a flat light guide member.

DE 10 2005 048 497 A1 relates to a vehicle head light having an LED, which is encapsulated in a first resin body.

### SUMMARY OF THE INVENTION

The present invention is defined in claims 1-5.

The present invention is a light assembly for vehicles including a vehicle component that is configured to form a portion of a motor vehicle. The light assembly also includes an outer member defining opposed inner and outer surfaces. The outer member comprises a sheet of material having a first area that transmits at least a substantial portion of light incident on the sheet through the sheet, and a second area that transmits substantially less light relative to the first area. The first and second areas together define a predetermined pattern. The light assembly also includes a light guide disposed adjacent the inner surface of the outer member. The light guide defines a light-receiving portion, and the light guide is made of a light-transmitting material that internally reflects a substantial portion of light introduced into the light guide at the light receiving portion. A light source is mechanically connected to the light guide adjacent the light-receiving portion, and the light source includes an electrically conductive circuit and at least one LED connected to the circuit. The light source further includes a thermal plastic polymer body encapsulating the one LED and at least a substantial portion of the circuit. Also, the light guide includes a body portion and an integrally-formed first connector, and the thermal plastic polymer body of the light source includes an integrally-formed second connector engaging the first connector and mechanically interconnecting the light guide and the light source. The light assembly further includes a base member fixed to the outer member to define therewith a water-tight cavity. The light guide and the light source are disposed within the watertight cavity.

The outer member may comprise a sheet of polymer material having a substantially uniform thickness of about 1.0 - 2.0 millimeters. The light guide may have a thickness of about 2.0 millimeters to about 5.0 millimeters.

One of the first and second connectors may be a protrusion, and the other of the first and second connectors may be an indentation, with the protrusion being received in the indentation. The protrusion and the indentation may be T-shaped. The protrusion may include planar opposite side surfaces, and a peripheral edge surface extending between the opposite side surfaces, wherein the peripheral edge surface is perpendicular to the opposite side surfaces.

The method of fabricating a lighting device according to claim 1 is not part of the present invention. The method includes the steps of providing an electrically-powered light source having a first connector. A sheet of light-transmitting material having generally smooth opposite side surfaces that internally reflect light introduced into the sheet is also provided. The method further includes cutting the sheet to form a light guide having a peripheral edge including a second connector. The first and second connectors are engaged to connect the light source to the light guide. The sheet of light-transmitting material may be cut utilizing a laser. The electrically-powered light source may include an electrical circuit element and an LED that is secured to the electrical circuit element. At least a portion of the LED and the electrical circuit element may be encapsulated in a thermoplastic polymer material. Also, the step of engaging first and second connectors may include causing the first and second connectors to slidably contact one another. The step of cutting the sheet may include forming one of a protrusion and a recess in the peripheral edge of the sheet, and encapsulating the LED may include forming a body surrounding the LED, wherein the body includes the other of a protrusion and a recess. A plurality of surface irregularities may be formed on one of the opposite sides surfaces of the light guide utilizing a laser, and the surface irregularities may form a predefined pattern. The light source and light guide may be positioned in a cavity of a base member, and a cover member may be sealed together with the base member such that the cavity is watertight. The cover member may comprise light-transmitting material, and a layer of light-blocking material may be applied to portions of a first side surface of the cover member to form a predefined pattern that is illuminated by the light source. The step of cutting the sheet to form a light guide may include cutting the sheet to form a T-shaped protrusion or recess. The electrically-powered light source may be encapsulated by a thermoplastic body that is molded around at least a portion of the LED.

A light assembly which is not according to the present invention includes an electrically conductive circuit and a plurality of LEDs mounted to the circuit. The light assembly also includes a light-transmitting thermoplastic polymer body encapsulating the LEDs and at least a portion of the circuit and defining inner and outer side faces. The polymer body includes smooth surface portions configured to internally reflect light from the LEDs, and irregular surface portions that disperse light from the LEDs such that the light from the LEDs escapes from the polymer body. A layer of substantially opaque material is disposed on the outer side face of the polymer body, and covers selected portions of the outer side face and substantially blocks escape of light from the polymer body at the selected portions. The layer of substantially opaque material defines open areas on the outer side face of a polymer body, and the open areas are illuminated by light from the LEDs to form a lighted pattern. The open areas may be formed by openings through the layer of substantially opaque material. The light assembly may also include at least one opaque member disposed in a selected one of the openings through the layer of substantially opaque material to define a gap between the opaque member and the edge of the one opening through which light can escape. The light assembly may also include a light-transmitting member extending over at least one of the openings and closing off the opening. The light-transmitting member may include a polymer body portion and a layer of light-transmitting material disposed on the body portion, wherein the layer of light-transmitting material has an appearance that is substantially similar to chrome when the LEDs are not illuminated. The light assembly may include a timer that turns off the LEDs after a preselected period of time.

### BRIEF DESCRIPTION OF THE DRAWINGS

Fig. 1 is a partially fragmentary view of a badge or emblem installed to a vehicle or the like not according to the present invention;

Fig. 2 is a fragmentary, partially exploded cross-sectional view taken along the line II-II; Fig. 1;

Fig. 3 is a partially exploded, fragmentary, cross-sectional view of a badge or emblem not according to the present invention;

Fig. 3A is an enlarged view of a portion of the badge or emblem of Fig. 3;

Fig. 4 is a partially exploded, fragmentary, cross-sectional view of a badge or emblem not according to the present invention;

Fig. 5 is an enlarged fragmentary view of a portion of the badge or emblem of Fig. 4;

Fig. 6 is a isometric view of a light assembly and doorsill according to the present invention;

Fig. 7 is an exploded isometric view of the lighted doorsill assembly of Fig. 6;

Fig. 8 is an exploded isometric view of the light guide and light source of Fig. 7;

Fig. 9 is a top plan view of the light guide and light source assembly of Fig. 8;

Fig. 10 is a cross-sectional view of the light guide and light source assembly of Fig. 9, taken along the line X-X;

Fig. 11 is a bottom plan view of the light guide and light source assembly of Fig. 10;

Fig. 12 is a fragmentary, enlarged view of a portion of the light source of Fig. 11 showing the internal electrical components;

Fig. 13 is a fragmentary, cross-sectional view of a portion of a light source according to another aspect of the present invention;

Fig. 14 is a fragmentary cross-sectional view of the lighted doorsill assembly of Fig. 6, taken along the line XIV-XIV;

Fig. 15 is a fragmentary exploded view of the lighted doorsill assembly of Fig. 14;

Fig. 16 is a cross-sectional view of another embodiment of the lighted doorsill assembly of Fig. 6;

Fig. 17 is a fragmentary exploded view of the lighted doorsill assembly of Fig. 16;

Fig. 18 is an isometric view of an electrical device not according to the present invention;

Fig. 19 is an isometric view showing internal components of the device of Fig. 18;

Fig. 20 is an isometric view showing the components of Fig. 19 during fabrication of the device of Fig. 18;

Fig. 21 is a cross sectional line taken along the line XXI-XXI, Fig. 20, showing the component in a mold tool during fabrication;

Fig. 22 is a cross sectional view taken along the line XXII-XXII, Fig. 20, showing the component in a mold tool during fabrication; Fig. 20;

Fig. 23 is a cross sectional view showing the components of Fig. 20 positioned in a second mold tool cavity immediately prior to injection of a second shot of molten polymer material;

Fig. 24 is an isometric view of an assembly utilized during fabrication of a device not according to the present invention;

Fig. 25 is an isometric view of a finished device including the assembly of Fig. 24.

Fig. 26 is a cross-sectional view of the assembly of Fig. 24 positioned in a mold tool prior to injection of molten polymer material during a first molding shot;

Fig. 27 is a cross-sectional view of the assembly of Fig. 24 positioned in the mold tool of Fig. 26 prior to injection of molten polymer material during a first molding shot, wherein the section line is taken across a different plane than that of Fig. 26; and

Fig. 28 is a cross-sectional view of an assembly formed by a first mold shot positioned in a mold tool not according to the present invention.

### DETAILED DESCRIPTION OF PREFERRED EMBODIMENT

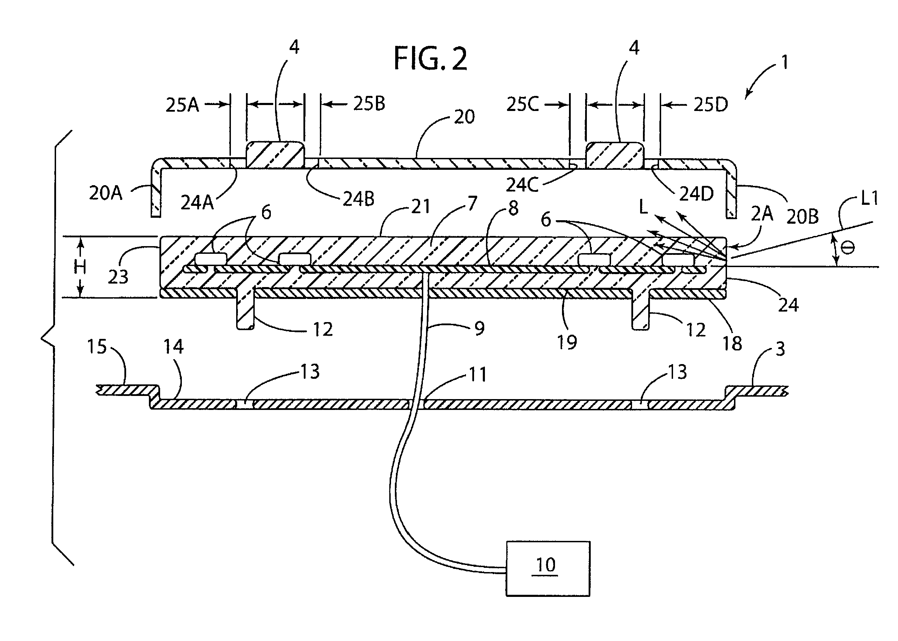

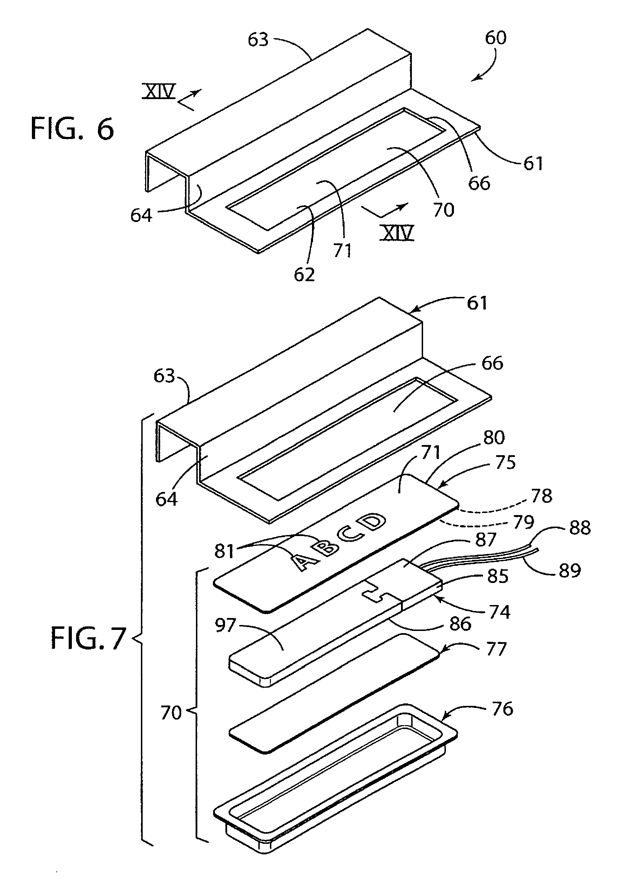

For purposes of description herein, the terms "upper," "lower," "right," "left," "rear," "front," "vertical," "horizontal," and derivatives thereof shall relate to the light assembly as oriented in Figs. 2-4. However, it is to be understood that various alternative orientations and step sequences may be assumed, except where expressly specified to the contrary. It is also to be understood that the specific devices illustrated in the attached Fig. 6 to 17 and described in the following specification are simply exemplary embodiments of the inventive concept defined in the appended claims. Hence, specific dimensions and other physical characteristics relating to the embodiments disclosed herein are not to be considered as limiting, unless the claims expressly state otherwise.

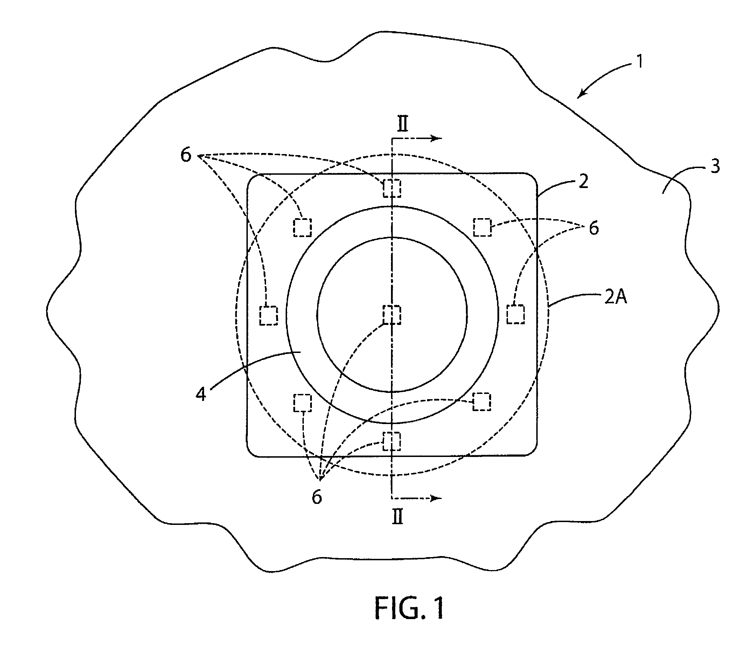

With reference to Fig. 1, a lighted device such as a badge or emblem 1 not according to the present invention includes a base 2 that is secured to a structure 3, and an emblem or badge design 4. As discussed in more detail below, the structure 3 may be a sheet metal portion of a fender of a vehicle or the like, or it may comprise a back portion of a seat of a vehicle, or other mounting structure. In the illustrated example, the design 4 has a ring-like shape. It will be understood that the design 4 may comprise virtually any shape or design. In particular, the design 4 comprises a logo or trademark of an auto manufacturer or the like, such that the badge or emblem 1 readily identifies the make and/or model of the vehicle. Base 2 may be quadrilateral, or any other shape. For example, the base may be shaped to match or complement the shape of design 4 as shown by the dashed line 2A (Fig. 1). As also described in more detail below, the base 2 may include a plurality of LEDs 6 that provide for back lighting of the design 4.

With further reference to Fig. 2, a light device such as a badge or emblem 1 not according to the present invention includes a base 2A having a plurality of LEDs 6 embedded in light-transmitting polymer material 7. Polymer material 7 is preferably clear, but it may comprise a colored translucent material, or it may comprise other light-transmitting material. A conductor 8 embedded within the clear polymer material 7 supplies electrical power to the LEDs 6. One or more electrical power lines 9 are electrically connected to the conductor 8, and supply power from a power source 10. The electrical power lines 9 pass through an opening 11 in the structure 3. It will be understood that the power source 10 may include the necessary circuitry (not shown) to drive the LEDs 6 in addition to a conventional battery power source of the type utilized for vehicles and the like. Alternately, the circuit (not shown) for driving the LEDs may be positioned on conductor 8, and embedded in polymer material 7. The base 2A may be fabricated according to the arrangement disclosed in detail in U.S. Patent Application Publication No. 20080062711, entitled ELECTRICAL DEVICE HAVING BOARDLESS ELECTRICAL COMPONENT MOUNTING ARRANGEMENT, published on March 13, 2008.

The base 2A may include a pair of mounting/locating posts or bosses 12 formed from the clear polymer material 7. The posts or bosses 12 are received in openings 13 in structure 3 to locate the base 2A in the proper position on structure 3. The structure 3 may include an indentation or recessed area 14 that receives the base 2A to reduce the extent to which the badge or emblem 1 protrudes above the surface 15 of structure 3. It will be understood that the thickness or height "H" of the base 2A is typically quite small, in the range of about 3-6 mm. The thicknesses of the components of the base 2A are exaggerated in Fig. 2 for purposes of illustration. A layer of adhesive 18 on lower side 19 of base 2A secures the base 2A to the structure 3. In a preferred embodiment, the adhesive 18 is a pressure sensitive adhesive ("PSA"). However, other suitable adhesives or securing arrangements may also be utilized in accordance with the present invention.

The badge or emblem 1 of Fig. 2 includes a thin layer of material 20 that may be secured to a top surface 21 and to side surfaces 22 and 23 of clear polymer material 7. The thin layer of material 20 comprises film, paint, or other substantially opaque material that blocks light generated by LEDs 6. Layer 20 may be colored to provide the desired appearance for the badge or emblem 1. Edges 24A, 24B, 24C, and 24D of layer 20 are spaced apart from the material forming the design 4 to form gaps 25A, 25B, 25C, and 25D, respectively. The design 4 is preferably a solid member made of opaque plastic polymer, metal, or other suitable material that blocks light from LEDs 6 and provides the desired wear and appearance characteristics. The thin layer 20 and material of design 4 both block the light from the LEDs 6, such that the light can only escape through the gaps 25A-25D. This provides a unique edge lit arrangement that accents the design 4. In the illustrated example, the thin film 20 includes edge portions or flaps 20A and 20B that extend over the side surfaces 23 and 24, respectively, of the clear polymer material to thereby prevent escape of light from the LEDs 6 at the edge or side surface 23 and 24.

LEDs 6 are preferably side-emitting LEDs that would emit light sideways (e.g., parallel to conductor 8) if mounted flat on conductor 8. LEDs 6 are, however, preferably mounted to conductor 8 at an angle "θ" of about 30°. Also, LEDs 6 are oriented to emit light "L" towards side surfaces 23 and 24. Light L incident on side surfaces 23 and 24 is reflected inwardly back into polymer material 7. The line "L1" of Fig. 2 represents the path light from an LED 6 would travel if the light were not reflected intervally. Mounting LEDs 6 at an angle θ facilitates dispersion of the light from LEDs 6 within the polymer material 7 and avoids or reduces "hot spots" (areas of greater light intensity) that could otherwise be formed if the LEDs 6 were mounted in a flat configuration (i.e., θ = 0°). Top surface 21 of polymer material 7 may be grained, frosted, or otherwise non-smooth to provide for dispersion (escape) of light from surface 21. Top surface 21 may have an irregular or rough surface in the areas of gaps 25A-25D to promote dispersion of light in these areas, and top surface 21 may be smooth in other areas to promote internal reflection of light L.

Because the LEDs 6 and conductors 8 are completely embedded within the clear polymer material 7, the badge or emblem 1 is completely or substantially waterproof, thereby providing a high degree of durability and weather resistance. Also, because the LEDs 6 draw a relatively low amount of electrical power, the badge or emblem 1 does not significantly effect the electrical power system of the vehicle. The badge or emblem 1 may be operably connected to a timer or the like that continues to light the LEDs 6 for a period of time after the vehicle ignition or other lights are turned off. In this way, a parked vehicle in a parking lot or the like having an emblem 1 will provide a unique lighted display of the badge or emblem even after the vehicle is turned off. Because the power requirements of the LEDs 6 are very low, the timer may be configured to leave the badge or emblem 1 on for a relatively long period of time, such as 10 minutes, 20 minutes, 30 minutes, or an hour or more. Thus, if the vehicle includes a timer that turns off the vehicle headlights and/or interior lights after a few minutes, the emblem 1 may remain illuminated for a substantially longer period of time.

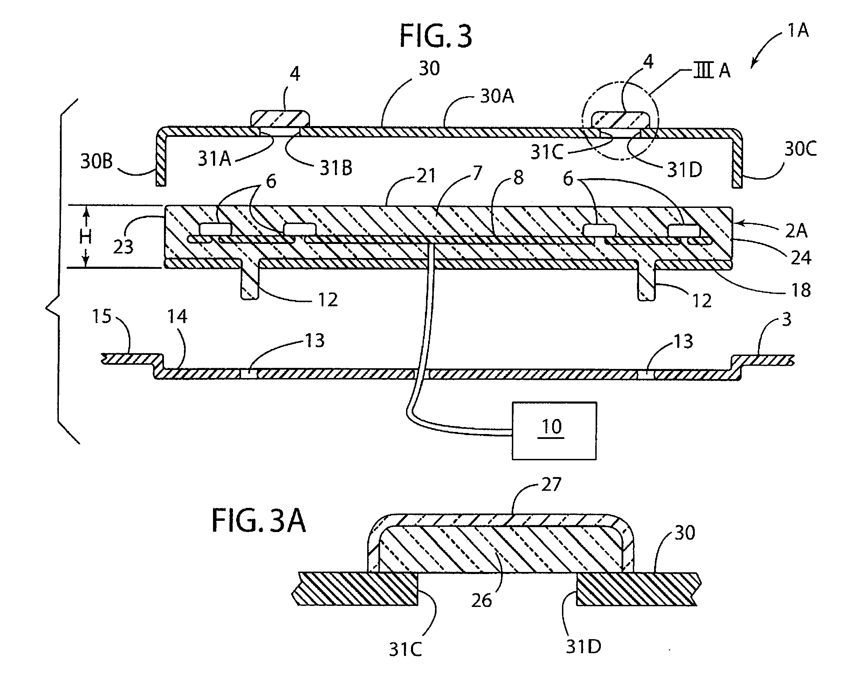

With further reference to Fig. 3, a device such as a badge or emblem 1A not according to the present invention includes a base 2A having side-emitting LEDs 6 and a conductor 8 embedded in a clear polymer material 7 in substantially the same manner as illustrated in Fig. 2. LEDs 6 are mounted at an angle (i.e. not flat) as discussed above in connection with Fig. 2. However, unlike the badge or emblem 1 of Fig. 2, edges 31A, 31B, 3 1 C and 31D of material 30 are positioned below the material forming the designs 4, such that no gap or the like is formed around the designs 4. Material 30 may be opaque paint, polymer, or other such material. With further reference to Fig. 3A, design 4 may comprise a light-transmitting or clear polymer material 26 with a thin layer of light-transmitting material 27 disposed over the polymer material 26. Layer 27 is a light-transmitting material that produces a chrome-like appearance when LEDs 6 are turned off. However, layer 27 transmits light and illuminates design 4 when LEDs 6 are turned on by transmitting light from LEDs 6 through layer 27. Layer 27 may be a LensLite^{®} film that is commercially available from Craft Originators of Hamilton, Ontario, Canada. Layer 27 may comprise one or more layers of material as disclosed in U.S. Patent No. 6,101,748, the entire contents of which are incorporated by reference. Alternately, layer 27 may comprise a light-transmitting layer that is translucent, a colored layer of polymer material or paint. Still further, layer 27 may be eliminated, and the polymer material 26 may comprise a colored translucent material providing a lighted design 4.

As discussed above, although the base 2 illustrated in Fig. 1 has a generally quadrilateral shape, the base of the badge or emblem 1 may be chosen to have a shape as shown by the dashed line designated 2A in Fig. 1 that complements the shape of the design 4. As also discussed above, the design 4 may have virtually any shape or configuration as required to properly identify the particular make or model of vehicle, or provide another desired decorative effect. Accordingly, the shapes illustrated in the present application for the design 4 and base 2 are merely for purposes of illustration to provide for understanding of the present invention, and are not to be construed to be limiting with respect to the shape of these components.

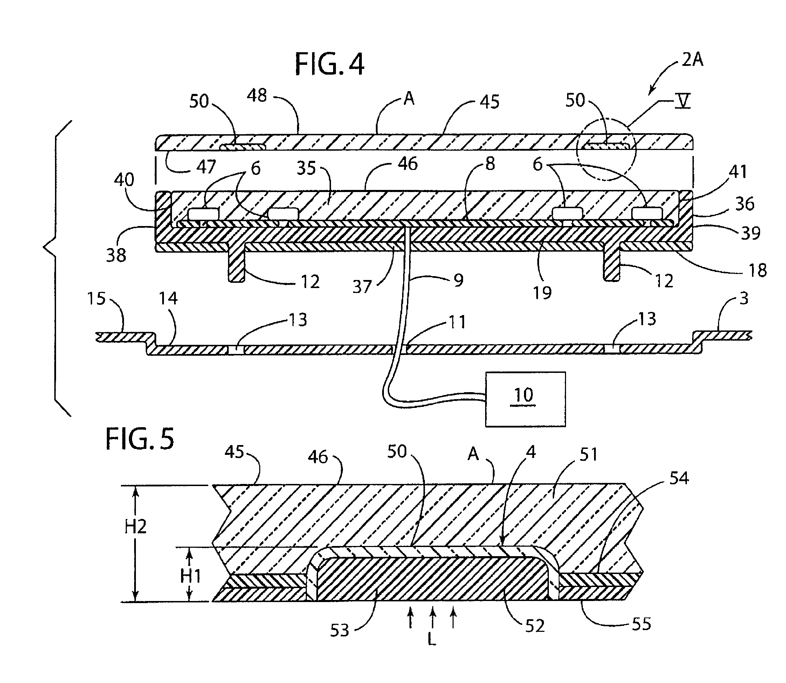

With further reference to Fig. 4, a badge or emblem 1B not according to the present invention includes one or more side-emitting LEDs 6 that are embedded in light-transmitting or clear polymer material 35. LEDs 6 are mounted at an angle (i.e. not flat) as discussed above in connection with Fig. 2. Electrical power is supplied to the LEDs 6 via a conductor 8. In addition to the clear polymer material 35, the badge or emblem 1B further includes a portion 36 made of a non-translucent polymer material such as a black ABS material. In the illustrated example, the portion 36 includes a main section 37 forming a layer adjacent the conductor 8, and upstanding edge or flange-like portions 38 and 39 that extend around the side surfaces 40 and 41, respectively of clear polymer material 35. Edge portions 38 and 39 prevent escape of light from LEDs 6 from the interfaces 40 and 41 formed where the non-translucent material 36 meets the clear polymer material 35.

Light from LEDs 6 is reflected inwardly at interfaces 40 and 41, and escapes through layers 50 embedded in a design or badge component 45. Design component 45 may be secured to a front surface 46 utilizing adhesive or the like (not shown) disposed on the lower surface 47 of the material forming the design 45. It will be understood that the design 45 may have a shape similar to the material forming design 4 of the badge or emblem 1 as illustrated in Fig. 1, or the material forming the design component 45 may have another shape as required for a particular application.

The badge or design 45 may have layers of material 50 embedded therein to form the design 4. More specifically, with reference to Fig. 5, the design or badge 45 may include a clear or translucent polymer body 51, with a thin layer of material 50 embedded in polymer body 51 to form logo or design 4. The layer of material 50 may be a LensLite^{®} film described in aforementioned U.S. Patent No. 6,101,748. It will be understood that the embossed layer 50 may actually comprise a plurality of layers as required to provide the desired effect. In a preferred embodiment, the layer 50 provides a chrome-like appearance when the design or badge 45 is viewed from the "A" surface. The layer 50 is embossed to provide a non-planar appearance. In the illustrated example, the layer 50 is embossed to a depth "H1" of about 1.5 mm, and the overall thickness "H2" of the badge 45 is about 3 mm. However, it will be understood that virtually any thickness may be utilized as required for a particular application. For example, layer 50 need not be embossed, and could comprise a flat layer or material. Clear or other light-transmitting polymer material 52 is disposed in the cavity 53 formed by the embossed layer 50. When light "L" from LEDs 6 is incident upon the clear polymer material 52, it is transmitted through the clear polymer material 52, the embossed layer 50, and through clear polymer material 51. The light L then escapes through outer surface 46 of polymer material 51.

First and second layers of paint or other opaque film 54 and 55 are disposed on the clear polymer material 51 in the areas surrounding the embossed layer 50 to block the transmission of light "L" from the LEDs 6. Layer 55 is preferably a layer of polymer material, black paint or the like that blocks the transmission of light. Layer 54 comprises a paint or other polymer layer that may be colored to provide the desired background color surrounding the chrome embossed layer 50. Pressure sensitive adhesive ("PSA") may be utilized to secure the design or badge 45 to the front side surface 46 of the clear polymer material 35 (Fig. 4) and the black polymer portion 36. Preferably, the PSA is not applied to the clear polymer material 52 so as not to block the transmission of light "L" through the embossed layer of material 50.

The light device or assembly/badge/emblem 1 of the present invention may be utilized on the exterior of vehicles, such as on a fender, bumper, or the like. Alternately, the light assembly 1 may be positioned, for example, on the back of a seat or the like. Still further, a light assembly 1 according to the present invention may be mounted to the exterior of a building, house, or other stationary structure to thereby provide for a decorative or informative effect.

With further reference to Fig. 6, a light assembly or device according to the present invention comprises a vehicle component such as a doorsill assembly 60 having a primary structure 61 including an elongated flat portion 62, and an upwardly-extending channel portion 63. In use, a vehicle door (not shown) is positioned above the flat portion 62 of primary structure 61, and side surface 64 of channel portion 63 disposed directly adjacent, or in contact with, a lower edge portion (not shown) of the vehicle door. A light assembly 70 (see also Fig. 7) is mounted to the primary structure 61, and includes an upper surface 71 that is visible through an opening 66 in flat portion 62 of primary structure 61.

With reference to Fig. 7, light assembly 70 includes a light source/guide assembly 74, an upper member or appliqué 75 forming upper surface 71 a backing member 76, and an optional reflective layer or member 77.

The upper member 75 is made of a thin sheet of polycarbonate or other suitable polymer material having a thickness of about 1.0 mm to 2.0 mm. In the illustrated example, upper member 75 is about 1.5 mm thick. The upper member 75 may be made from a layer or sheet 80 of polymer material having light-transmitting properties, and ink 78 or other light-blocking material is applied to a lower surface 79 of the sheet of material 80, leaving areas 81 without ink 78, such that light from light source/guide assembly 74 may be transmitted through the areas 81. The areas 81 may form letters, designs, or the like. In particular, the areas 81 may form letters spelling out the brand or model of the vehicle that can be read by a user when the doors open to expose the lighted doorsill assembly 60 (Fig. 6). The areas 81 may also form designs or shapes other than letters, numbers, etc. The upper surface 71 of sheet 80 may comprise a protective coating of wear-resistant material to improve durability of the light assembly 70. One example of a suitable material for the coating or layer of surface 71 is SERIGLAZE^{®} product available from Serigraph, Inc. of West Bend, WI. The sheet 80 is preferably a clear or translucent material. In particular, the sheet 80 may comprise a white polymer material that provides sufficient light transmission capability to illuminate the areas 81, while simultaneously not permitting a user to view the light source/guide assembly 74 and/or vacuum member and reflective member 77 through the areas 81.

The light source/guide assembly 74 includes a light source 85 that is connected to a light guide 86 at a joint 87. Electrical lines 88 and 89 extend from the light source 86, and connect to a conventional 12 volt vehicle electrical power supply.

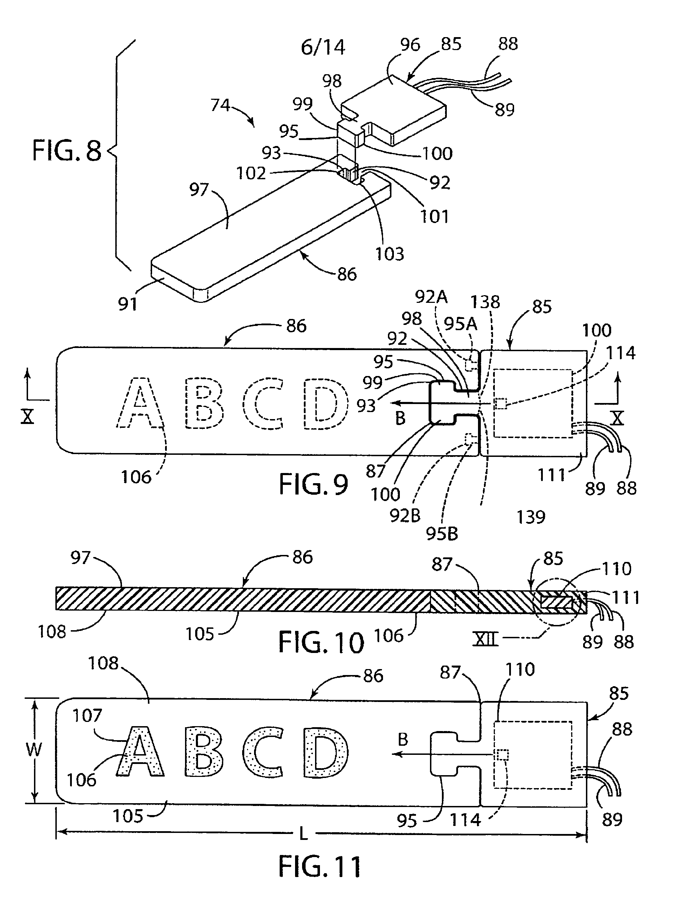

With further reference to Fig. 8, the light source/guide assembly 74 includes a light guide 86 and a light source assembly 85. The light guide 86 may be formed from a sheet of acrylic material or other suitable polymer having a relatively uniform thickness. The thickness of the light source 85 and light guide 86 will vary depending upon the requirements of a particular application. In the illustrated example, light source 85 and light guide 86 have a thickness in the range of about 2.0 - 4.0 mm, and more preferably about 3.0 mm. However, light source 85 and light guide 86 could have different thicknesses. In the illustrated example, the light guide 86 is cut from a large sheet of material to form a perimeter 91 including a recess such as inwardly-extending portion 92 with a surface 93 having a shape that closely corresponds to a protrusion 95 of light source assembly 85. The light guide 86 may be formed by laser-cutting, sawing, or otherwise cutting a sheet of polymer material. Alternately, the light guide 86 may be molded utilizing a suitable polymer material or the like. As described in more detail below, the light source assembly 85 includes one or more LEDs and other electrical components that are molded into polymer body 96. In the illustrated example, the light guide 86 comprises a rectangular prism, with the exception of the inwardly-extending portion 92. Light from the light source assembly 85 is reflected internally within the light guide 86, and subsequently escapes from the upper surface 97 and through the areas 81 (Fig. 7) of upper member 75.

The protrusion 95 of light source 85 is configured to be closely received within the recess or inwardly-extending portion 92 of perimeter 91 of light guide 86 to thereby mechanically and optically interconnect the light source assembly 85 and light guide 86. In the illustrated example, the protrusion 95 is generally T-shaped in plan view (Fig. 9), with a first portion 98, and transversely-extending portions 99 and 100. The inwardly-extending portion 92 of light guide 86 includes a first portion 101 corresponding to the first portion 98 of protrusion 95, and side portions 102 and 103 corresponding to transverse portions 99 and 100, respectively, of protrusion 95 of light source assembly 85. The protrusion 95 may be dimensioned slightly larger than the inwardly-extending portion 92 of perimeter 91 of light guide 86 to thereby form an interference fit to mechanically interconnect the light source assembly 85 to the light guide 86 without the use of adhesives. Adhesive material (not shown) may optionally be applied to the protrusion 95 and/or inwardly-extending portion 92 immediately prior to assembly to provide for secure connection between the light source assembly 85 and light guide 86. Also, to ensure that the light source assembly 85 is optically coupled to the light guide 86, a small amount of light-transmitting material such as a clear sealant or adhesive material may also be applied to the protrusion 95 and/or inwardly-extending portion 82 of perimeter 91 at the time of assembly.

With further reference to Figs. 9-11, light guide 86 includes irregular surface portions 106 that form a dispersion pattern that causes light from the light source assembly 84 to be dispersed within light guide 86 towards upper surface 97 of light guide 86, such that the light escapes from upper surface 97 of light guide 86. In the illustrated example, the outline 107 of the dispersion pattern 106 is in the form of letters having a shape that is substantially similar to the light-transmitting areas 81 (Fig. 7) of upper member 75. The dispersion pattern 106 may have the same size and shape as areas 81, or it may be somewhat larger or smaller. In general, the dispersion pattern 106 may be somewhat larger than the areas 81 to ensure that the areas 81 are fully illuminated, and has a similar shape to provide for efficient dispersion of light adjacent light-transmitting areas 81 of upper member 75. In the illustrated example, the dispersion pattern 106 is formed on lower surface 105 of light guide 86 by a laser. The dispersion pattern 106 comprises a plurality of small surface irregularities such as low spots, high spots, or a combination of both, produced by a laser incident upon the lower surface 105. It will be understood that the boundary line 107 is provided for purposes of illustrating the outline of the dispersion pattern 106 relative to the adjacent smooth portions 108 of lower surface 105 of light guide 86, but the dispersion pattern does not necessarily include an actual line 107 formed on light guide 86.

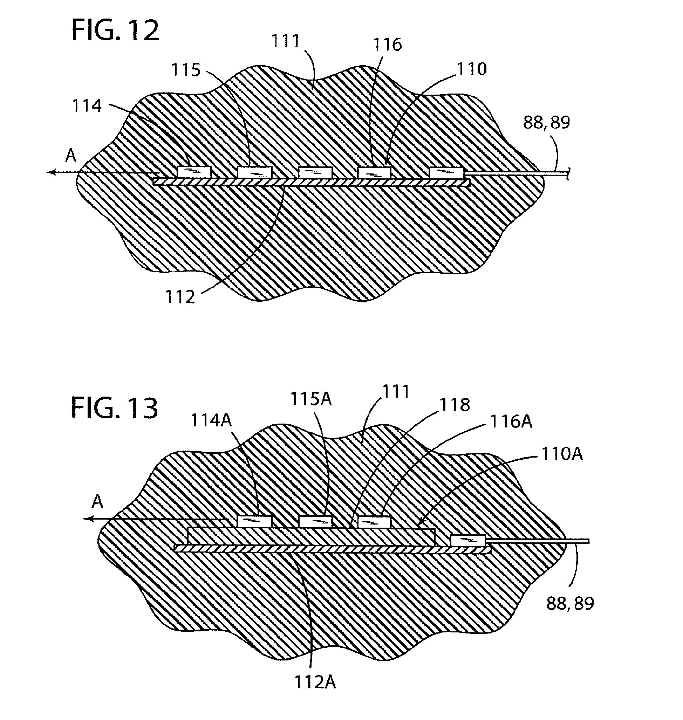

With reference to Fig. 10, light source assembly 85 includes an internal electrical assembly 110 that is embedded in a polymer body 111. With further reference to Fig. 12, the electrical assembly 110 may include conductive circuit elements 112, and one or more electrical components 115, 116 such as resistors, diodes, capacitors, or the like that are soldered or otherwise electrically and/or mechanically connected to the circuit elements 112. In the illustrated example, the electrical components include a side-emitting LED 114 that is configured to emit light in the direction of the arrow "A", and one or more additional electrical components 115 and 116 that are also secured to the conductive elements 112. One or more conductive lines 88 and 89 supply power to the circuit elements 112, and extend outside of the polymer body 111. The side-emitting LED 114 and/or other electrical components 115, 116 may be secured to the circuit elements 112 and molded into the polymer body 111 according to the arrangement disclosed in U.S. Patent Application Publication No. 2008/0062711, entitled ELECTRICAL DEVICE HAVING BOARDLESS ELECTRICAL COMPONENT MOUNTING ARRANGEMENT, published on March 13, 2008.

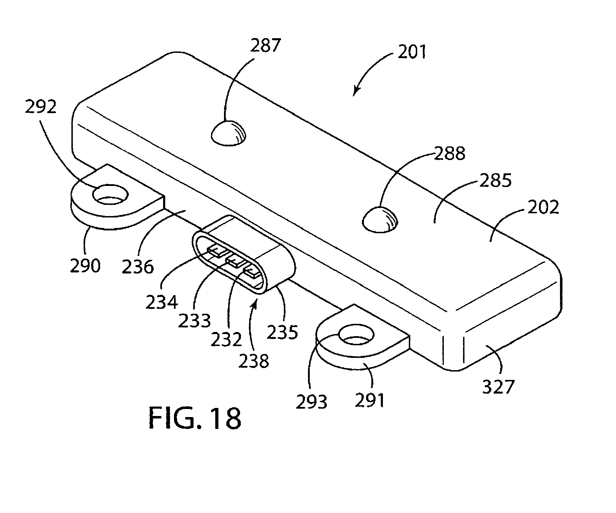

With reference to Fig. 13, the light source assembly 85 may comprise an electrical assembly 110A having a printed circuit board 118 that is soldered or otherwise secured to circuit elements 112A, with a side-emitting LED 114A and other electrical components 115A and 116A being mounted to the printed circuit board 118. The electrical assembly 110A may be fabricated as described in more detail below in connection with Figs. 18-28. The LED 114A may comprise a red-green-blue ("RGB") LED configured to provide different colors as required for a particular application. Alternately, the RGB LED may be configured to change colors depending upon specific operating conditions (e.g. the ambient light level), such that the light assembly 70 (Fig. 6) provides a different color light under different operating conditions. The electrical components 115, 116 etc. are configured to drive the LED 114 (Fig. 12) or 114A (Fig. 13) when a conventional 12 volt D.C. power supply is connected to the lines 88 and 89. This permits the light assembly 70 to be connected to a conventional 12 volt vehicle power source (or other conventional power source). Although the light source 85 is illustrated as being supplied with power by electrical lines 88 and 89, it will be understood that the light source assembly 85 could be configured to include an electrical receptacle or the like to provide a plug-type connection as described in the above-identified Application Nos. 11/842,606 and 61/013,097.

In the illustrated example, the LEDs 114/114A are positioned such that light from the LED 114 is generally transmitted/projected through the protrusion 95 (see also Figs. 9 and 11) in the direction of the arrow "B". The light from the LED 114 is thereby transmitted into the light guide 86, such that the light is reflected internally until it escapes through the upper surface 97 of light guide 86. Alternately, the light source assembly 85 may include a pair of spaced-apart protrusions 95A and 95B (Fig. 9) that are received in corresponding inwardly-extending portions 92A and 92B, respectively, of light guide 86. If the light source 85 and light guide 86 are configured in this way, a flat surface 138 is formed on polymer body 111 of light source 85 that fits closely against a corresponding flat surface 139 on light guide 86, such that light from LED 114 is transmitted through the flat surfaces 138 and 139 of polymer body 111 and light guide 86, respectively.

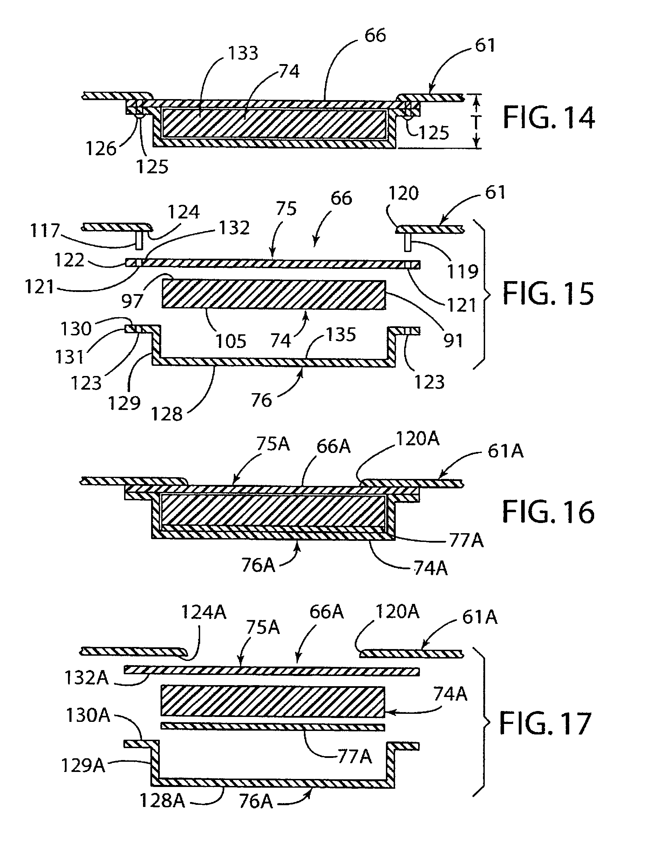

With further reference to Figs. 14 and 15, the primary structure 61 of lighted vehicle component or doorsill assembly 60 may be made of a polymer material, with posts 119 that extend downwardly adjacent edge 120 of opening 66. The upper member 75 includes a plurality of openings 121 adjacent the peripheral edge 122 of upper member 75, and backing member 76 includes a plurality of openings 123. During assembly, the posts 119 are inserted through the openings 121 of upper member 75, and through openings 123 of backing member 76, and the ends 125 (Fig. 14) of posts 119 are then melted to form an enlarged head or retainer portion 126 that physically interconnects the backing member 76 to the primary structure 61. The backing member 76 includes a main web 128, and a side wall or side web 129 that extends transverse relative to the base web 128. An outwardly extending flange portion 130 extends outwardly from the side web 129, and forms a peripheral edge 131. In the illustrated example, webs 128 and 129 have a thickness in the range of 0.10 - 0.20 mm and preferably about 0.15 mm. When the posts 119 of primary structure 61 are melted, the flange portion 130 of backing member 76 tightly clamps the outer edge portion 132 of upper member 75 between the flange 130 and the primary structure 61, thereby forming a water-tight seal. The primary structure 61, upper member 75, and backing member 76 together define a cavity 133, and the light source/guide assembly 74 is disposed within the cavity 133.

In addition to, or instead of, the posts 119, adhesive material, sealant, or the like may also be applied to the flange 130 of backing member 76, edge portions 132 of upper member 75, and/or edge surfaces 124 of primary structure 61 to adhesively interconnect the primary structure 61, upper member 75, and backing member 76 and/or to provide a water tight seal. In the illustrated example, the upper surface 97 and lower surface 105 of light source/guide assembly 74 are not adhesively connected to the upper member 75 or backing member 76, respectively. The perimeter surface 91 of light source/guide assembly 74 may also be free of adhesive material. Because the light source/guide assembly 74 is not adhesively bonded to these other components, the problems associated with light diffusion/degradation, or the like that could otherwise occur due to adhesively bonding the light source/guide assembly 74 to the other components is alleviated or eliminated.

The cavity 133 is thereby sealed to form a watertight cavity housing the light source/guide assembly. This provides an assembly that is durable and resistant to moisture-related degradation.

In the illustrated example, the backing member 76 may be formed of an opaque polymer material that prevents escape of light from light source/guide assembly 74. Surface 135 of backing member 76 may comprise a layer of reflective material such as reflective ink, or a thin sheet of reflective material disposed on the main web 128 of backing member 76 to provide for increased reflection of light back into light guide 86 of light/guide assembly 74. With further reference to Figs. 16 and 17, the light assembly may alternately comprise a backing member 76A having flange portions 130A that are adhesively bonded to edge portions 123A of upper member 75A. Similarly, the upper member 75A may be adhesively bonded to the edge surface portions 124A of primary structure 61 A adjacent the peripheral edge 120 of opening 66A. A reflective member or layer 77A may be adhesively bonded to web 128A of backing member 76A to provide for increased reflection of light into light source/guide assembly 74A. The reflective member 77A may comprise a thin sheet of opaque polymer, such as a white polymer material having reflective qualities, and the backing member 76A may be made of an opaque, light-absorbing polymer material, such as a black polymer. The reflective member 77A may be adhesively bonded to the backing member 76A, or it may be integrally-formed with the backing member 76A utilizing an appropriate molding process.

In the illustrated example, the primary structure 61 has a thickness of about 1.0-2.0 mm, and preferably about 1.5 mm, in the vicinity of edge 120. Thus, in the illustrated example, the thickness "T" (Fig. 14) of the doorsill assembly 60 in the vicinity of light assembly 70 is about 5.0 mm. Also, in the illustrated example, light source/guide assembly 74 has a length "L" (Fig. 11) of about 40-50 mm, and a width "W" of about 15-25 mm. The main portion of body 111 of light source 85 is about 16-20 mm by 16-20 mm, and more specifically about 18 mm by about 18 mm (not including T-shaped protrusion 95).

An electrical device 201 (Fig. 18) includes an outer portion 202 formed from polymer material and the like that encapsulates internal electrical components 204. The internal electrical components 204 may include one or more printed circuit boards 205 and 206 ("PCB"), and one or more integrated circuits ("IC chips") 207-210 and/or one or more LEDs 211-213. In the illustrated example, the IC chips 207-210 may comprise microprocessors, light, temperature, or other sensors, or the like, and the LEDs 211 and 212 may comprise red-green-blue ("RGB") LEDs. The IC chips 207-210 and LEDS 211-212 may be soldered or otherwise connected to the surfaces 214 and 215 of PCBs 205 and 206, respectively. Alternately, conductive epoxy, adhesives, or the like, may also be utilized to secure the IC chips 207-210 and LEDs 211-212 to the PCBs 205 and 206. The IC chips 207-210 and LEDs 211-212 may include a plurality of leads 216 that are electrically and mechanically connected to conductive material 217 on the surfaces 214 and 215 of PCBs 205 and 206, respectively. The PCBs 205 and 206 may be constructed according to known methods, and the various electrical components such as the IC chips 207-210 and LEDs 211-212 may be connected to the conductive material 217 utilizing known methods. In addition to the IC chips 207-210 and LEDs 211-212, a variety of other electrical components such as resistors, capacitors, diodes, transistors, photosensors, inductors, and the like (not shown) may also be secured to the PCBs 205 and 206 if required for a particular application.

The PCBs 205 and 206 may be interconnected by a conductor 220 having a plurality of elongated sections 221-223 that are initially interconnected by transverse sections 224 and 225. The elongated sections 221-223 may be connected to the surfaces 214 and 215 of the PCBs 205 and 206 by soldering or other suitable electrical and mechanical connection. The conductor 220 is initially fabricated as a 1-piece member, and the transverse sections 224 and 225 are later cut to form three separate elongated sections 221-223. The number of elongated sections 221-223 utilize for a particular application may vary as required. In the illustrated example, the conductor 220 is stamped from sheet metal such as brass, copper, or other suitable conductive material. However, the conductor 220 may comprise wires, flexible circuits, or "ribbon cables," elongated conductive rails or the like.

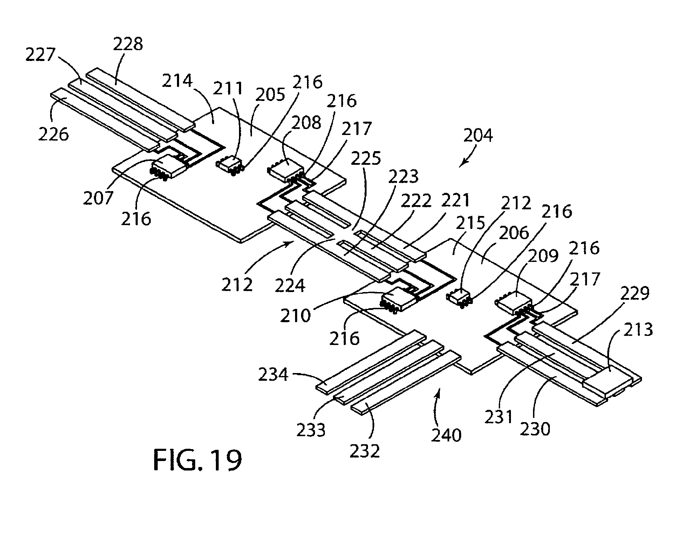

In addition to the conductor 220, additional conductors 226-234 may also be connected to the PCBs 205 and 206. The conductors 226-234 may be formed from stamped sheet metal, or the conductors 226-234 may comprise wires, rails, ribbon cables, or the like, depending upon the requirements of a particular application. With reference back to Fig. 18, outer portion 202 of electrical device 201 may include a portion 235 that extends outwardly from a side face 236 of body portion 237 of outer portion 202 to form, with conductors 232-234, an electrical receptacle 238 that can be coupled to a source of electrical power utilizing a standard connection. Referring again to Fig. 19, the electrical device 201 may include one or more electrical components such as a white LED 213 that are connected directly to conductors 229-231.

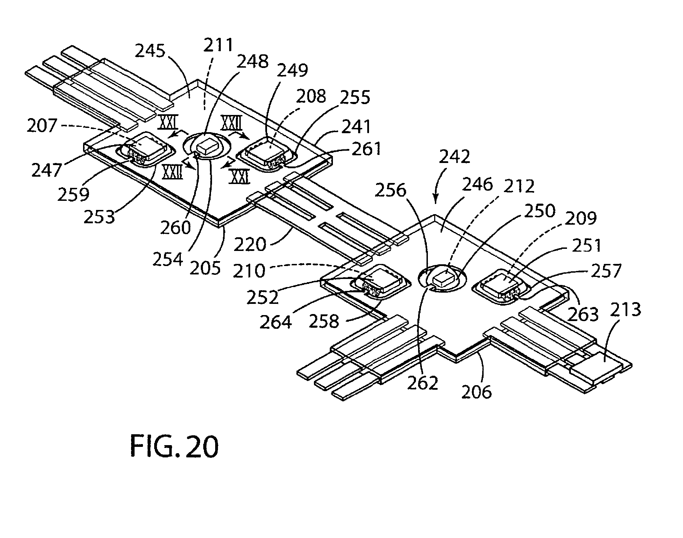

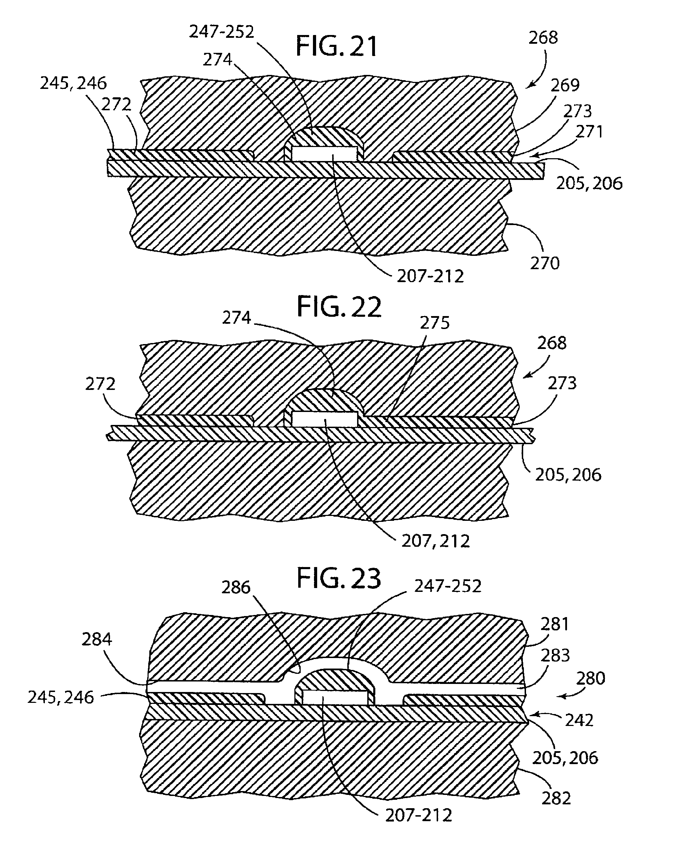

After the electrical components such as the IC chips, LEDs 211-212, and/or other components (not shown), and the conductors 220 and 226-234 are secured to the PCBs 205 and 206 via soldering or the like to form an assembly 240 of Fig. 19, the assembly 240 is positioned in a mold tool 268 (Figs. 21 and 22), and a polymer material 241 is molded onto the assembly 240 to form an intermediate assembly 242 (Fig. 20). The polymer material 241 forms layers of polymer 245 and 246 on upper surfaces 214 and 215 of PCBs 205 and 206, respectively. Capsule portions 247-252 are molded over the top of the IC chips 207-210 and LEDs 211-212, respectively. Channels or grooves 253-258 extend around the capsule portions 247-252, and small plastic bridges 259-264 extend between the layers of polymer 245 and 246 and the capsule portions 247-252. As discussed in more detail below, the bridges 259-264 result from small passageways in the mold cavity that supply molten polymer material from the cavity portions forming the layers of polymer 245 and 246, and the mold cavity portions forming the capsule portions 247-252 over the IC chips 207-210 and LEDs 211-212. The polymer material 241 preferably has a melting temperature that is lower than the materials utilized to form PCBs 205 and 206 and any of the other components utilized to form assembly 240.

With further reference to Fig. 21, the mold tool 268 utilized to form the intermediate assembly 242 of Fig. 20 includes a first mold part 269 and a second mold part 270. The PCBs 205 and 206 are positioned in mold cavity 271, and molten polymer material is injected into mold cavity portions 272-274 to form the layers 245 and 246, and the capsule portions 247-252. As shown in Fig. 22, a small passageway 275 fluidly interconnects cavity portion 273 with cavity portion 274 to thereby provide for flow of molten material from the cavity portion 273 into the cavity portion 274 to thereby form the capsule portions 247-252. The passageway 275 also fills with molten polymer material, thereby forming the bridge portions 259-264 (Fig. 20) interconnecting the capsule portions 247-252 with the layers 245 and 246 of PCBs 205 and 206, respectively. The passageway 275 has a very small cross sectional area, such that the flow of molten material into the cavity portion 274 around the electrical components 207-212 is restricted. Although the size of passageway 275 may vary depending upon the size of the electrical component being encapsulated, the type of polymer material being molded, or other variables, the cross sectional area of passageway 275 is generally about 0.004 inches², and typically falls in a range of about 0.002 inches² to about 0.050 inches². However, the cross sectional area of passageway 275 may fall outside this range, and the cross sectional area of passageway 259 may be as great as 0.100 inches², 0.25 inches², or more, or it may be as small as 0.001 inches² or less. In this way, the electrical components 207-212 are not subjected to the pressures and forces that would otherwise occur if the entire outer portion 202 of device 201 (Fig. 18) were to be molded in a single mold shot process. By isolating the electrical components 207-212 from the full force and/or heat that would otherwise be produced by the molten polymer being injected into the mold cavity if a single shot mold process were utilized, the electrical components 207-212 are substantially protected such that the components are not dislodged from the PCBs 205 and 206 and/or the conductors 226-234.

With further reference to Fig. 23, after the intermediate assembly 242 is formed in a first mold shot in mold tool 268, the intermediate assembly 242 is then placed in a cavity 283 of a second mold tool 280 having a first mold part 281 and second mold part 282. The PCBs 205 and 206 and/or the conductors 226-234 may include one or more apertures or other locating features (not shown) that engage pins or other such components (also not shown) of mold tools 268 and 280 to thereby position the assemblies 240 and 242 in the mold tools 268 and 280, respectively. Cavity 283 of second mold tool 280 may have an inner surface 284 that substantially corresponds to outer surface 285 of electrical device 201 (Fig. 18). Molten polymer is injected into the cavity 283 over the layers 245 and 246 previously molded onto PCBs 205 and 206. The molten polymer material injected into cavity 283 also encapsulates the capsule portions 247-252 previously formed in mold tool 268. Cavity 283 may include a concave surface 286 forming protrusions 287 and 288 over the LEDs 211 and 212 to thereby form lenses that distribute light in a predefined pattern. The polymer material utilized to form the outer portion 202 of device 201 may be transparent, or it may be covered to provide a specific appearance. The mold tool and process utilized to form the capsules 247-252 is similar to the tooling and process described in detail in co-pending U.S. Patent Application No. 11/842,606, filed on August 21, 2007. In addition to the electrical components mounted to the PCBs 205 and 206, one or more additional electrical components or devices such as a white LED 213 and/or other electrical components (not shown) may also be encapsulated and overmolded in a two-shot process that is similar to the process described above. However, the electrical components that are mounted directly to the conductors 226-234 are overmolded in substantially the same manner described in detail in the above-identified co-pending U.S. Patent Application No. 11/842,606. It will be understood that the mold tools 268 and 280 may include portions for encapsulating components mounted to PCBs 205 and 206 as described in detail above, and the same mold tools 268 and 280 may include other cavity portions that simultaneously encapsulate components such as white LED 213 that are mounted to conductors 226-234 in substantially the same manner as described in detail in the above-identified co-pending U.S. Application No. 11/842,606.

Referring again to Fig. 18, the polymer outer portion 202 may include integrally formed mounting features such as extensions 290 and 291 having openings 292 and 293, respectively, which receive fasteners or the like to secure the electrical device 201. Alternately, other mounting features such as bosses, apertures for mechanical fasteners, and the like (not shown), may be formed on outer portion 202 to locate and/or mount electrical device 201. Also, it will be understood that the conductors 220 and/or 226-234 do not necessarily need to be formed in a planar configuration. The conductors may be formed into a variety of three-dimensional, non-planar configurations, such that the circuit boards 205 and 206 may be positioned in a non-planar configuration relative to one another. In this way, the overall shape of the electrical device 201 may be non-planar as required for a particular application. For example, if device 201 comprises a light that must fit into a restricted space, the number and size of the PCBs, as well as the orientation and location of the PCBs relative to one another, may be chosen to fit closely within the confined area. In this way, a plurality of LEDs or other electrical components may be included in device 201, and the LEDs or other electrical components may be mounted to a PCB providing the proper electrical connections for the LEDs or other components, without the electrical device 201 being limited as it would be if a single large PCB were utilized to mount all of the components.

Also, because the PCBs and other electrical components are completely encapsulated in polymer material, these internal components are sealed such that they are not exposed to atmospheric moisture and other elements. Accordingly, the device 201 is very durable and weather-resistant, such that it may be utilized to provide for exterior lighting for vehicles, building structures, or the like. Still further, the various electrical components that may be needed to provide the required electrical power to the LEDs and/or other internal components may also be connected to the PCBs or other internal conductors. In this way, a conventional 12-volt DC power source may be connected to the electrical receptacle 238 (Fig. 1), and the electrical components mounted to the PCBs 205 or 206 and/or to the conductors 226-234 may be utilized to provide the proper voltage and current to the LEDs and/or other components.

According to one aspect of the present invention, one of the IC chips 207-210 may comprise a light intensity sensor that turns on one or more of the LEDs 211-213 if the device 201 is exposed to sufficiently low-light conditions. The electrical device 201 may comprise a lighted badge or emblem that can be secured to an outer surface of a motor vehicle or the like. If the device 201 includes sensors that are molded into the device 201, the badge or emblem may be configured to be automatically illuminated when the vehicle is exposed to low-light conditions.

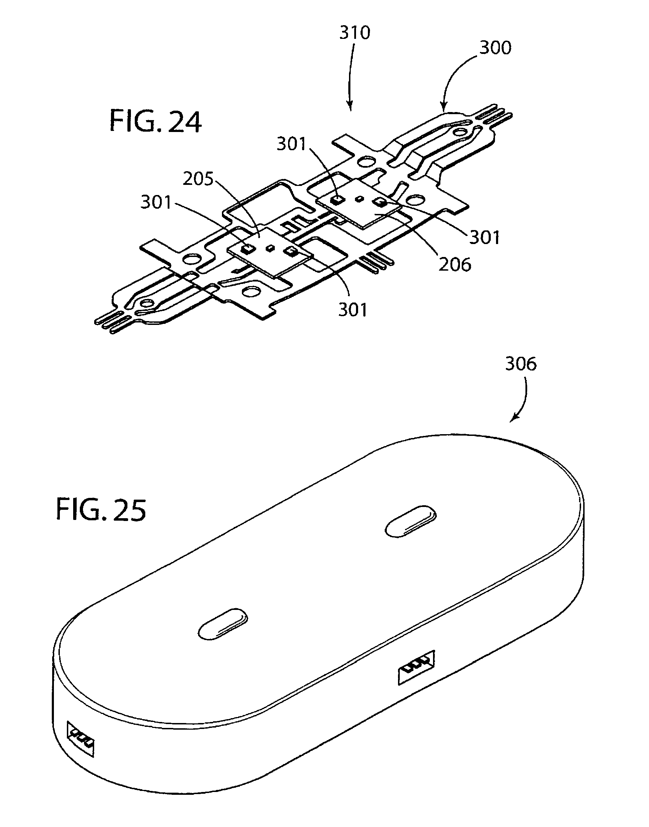

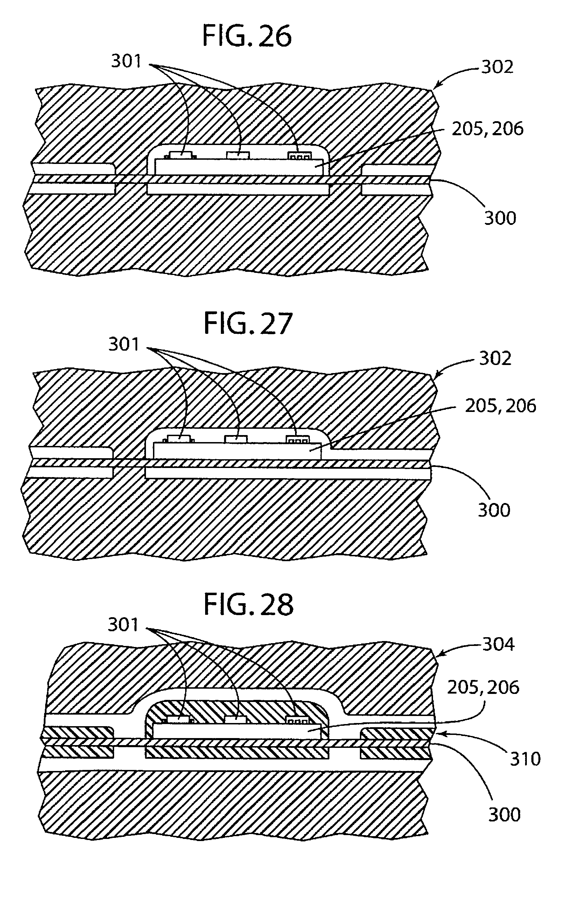

With further reference to Fig. 24, not according to the present invention, the PCBs 205 and 206 may be initially mounted to a single large conductive circuit element or web 300 that is formed from stamped sheet metal or the like. The conductive circuit element 300 may include a plurality of conductive portions that are initially interconnected by transverse sections such as the transverse sections 224 and 225 (Fig. 19) that are cut after the PCBs are attached to the conductive circuit element 300. The PCBs 205 and 206 may be connected to the conductive circuit element 300 utilizing soldering or other known methods. Various electrical components such as LEDs, IC chips, resistors, or the like, may be secured to the PCBs by soldering or the like, and additional electrical components may be secured directly to the conductive web via soldering or the like. The resulting assembly 310 is then overmolded in a two-shot process wherein capsule portions are first molded around the electrical components 301 in first mold tool 302 as shown in Figs. 26 and 27 in a manner similar to the process as described in more detail above in connection with Figs. 19-23 to form a completed device 306 (Fig. 25). One or more additional molding shots are then applied using a second mold tool 304 as shown in Fig. 28 to provide a finished part that may have an exterior configuration that is substantially similar to electrical device 201 (Fig. 18).

With further reference to Fig. 12, assembly 310 (Fig. 24) may, alternately, be placed in a mold tool 312 during a first mold step or shot. Mold tool 312 includes an upper cavity 313 and an optional lower cavity 314. Upper cavity 313 includes a ring-like ridge or protrusion 315 that forms a small gap 316 around components 301. The gap 316 restricts the flow of molten polymer material around PCBs 205 and 206, and around components 301 during the first molding shot. The gap 316 thereby provides for a reduced flow of molten polymer material such that a small passageway 275 (Fig. 22) is not required for mold tool 312. Mold tool 312 may, optionally, include a lower cavity 314 having a ring-like protrusion 317 forming a small gap 318 to restrict the flow of molten polymer material in the region of the PCBs 205 and 206 on the opposite side of circuit element 300.

With further reference to Fig. 13, a mold tool 320 forms a cavity 324 and includes an upper tool part 321 having a ring-like ridge or protrusion 322 forming a small gap 323 to restrict the flow of molten polymer material around an electrical component 207-212 mounted to a PCB 205 (or to a circuit element 300). Surface 325 of mold part 321 fits tightly against electrical component 207-212, such that the electrical components of the intermediate part produced by a first mold shot or step in tool 320 are surrounded by a raised ridge of polymer material, with the upper surface 326 of the components 207-212 being exposed.

The intermediate parts produced by the mold tool 312 (Fig. 12) and the mold tool 320 (Fig. 13) may be positioned in a second mold tool such as mold tool 280 (Fig. 23), or mold tool 304 (Fig. 28) to provide for second (or more) mold shots to form a finished device.

In the foregoing description, it will be readily appreciated by those skilled in the art that modifications may be made to the invention without departing from the concept disclosed herein. Such modifications are to be considered as included in the following claims, unless these claims by their language expressly state otherwise. Unless expressly stated otherwise, features of one embodiment or version of the present application are not mutually exclusive with respect to other embodiments or versions of the invention.

## Claims

1. A light assembly for vehicles, comprising:
a vehicle component (60) configured to form a portion of a motor vehicle;
an outer member defining opposed inner and outer surfaces, the outer member comprising a sheet of material (80) having a first area (81) that transmits at least a substantial portion of light incident on the sheet (80) through the sheet (80), and a second area covered by a light-blocking material (78) that transmits substantially less light relative to the first area (81), such that the first and second areas together define a predetermined pattern;
a light guide (86) disposed adjacent the inner surface of the outer member, the light guide (86) defining a light-receiving portion, wherein the light guide is (86) made of a light-transmitting material that internally reflects a substantial portion of light introduced into the light guide (86) at the light-receiving portion, the light guide (86) including a body portion and an integrally-formed first connector (92, 93, 101, 102);
a light source (85) mechanically connected to the light guide (86) adjacent the light-receiving portion, the light source (85) including an electrically conductive circuit (112, 112A) and at least one LED (114, 114A) connected to the circuit (112), the light source (85) further including a thermoplastic polymer body (96) encapsulating the one LED (114, 114A) and at least a substantial portion of the circuit (112, 112A), the thermoplastic polymer body (96) of the light source (85) includes an integrally-formed second connector (98, 99, 100) engaging the first connector (92, 93, 101, 102) and mechanically interconnecting the light guide (86) and the light source (85);
a base member (76) fixed to the outer member to define therewith a watertight cavity (133), and wherein the light guide (86) and the light source (85) are disposed within the watertight cavity (133);
wherein the light guide (86) is formed as a sheet and
wherein the light source (85) and the light guide (86) have the same thickness.

2. The light assembly of claim 1, wherein:
the outer member comprises a sheet of polymer material having a substantially uniform thickness of 1.0 - 2.0 millimeters.

3. The light assembly of claim 1 or 2, wherein:
a selected one of the first (92, 93, 101, 102) and second (98, 99, 100) connectors comprises a protrusion, and the other of the first (92, 93, 101, 102) and second connectors (98, 99, 100) comprises an indentation, and wherein the protrusion is received in the indentation, wherein:
the protrusion is preferably T-shaped.

4. The light assembly according to one of the preceding claims, wherein:
the vehicle component (60) includes a planar web portion having an opening therethrough (66), and wherein:
the outer member extends across said opening.

5. The light assembly according to one of the preceding claims, wherein:
the base member (76) comprises a central web (128) having a peripheral edge(131) , and an upstanding side wall (129) extending transverse relative to the central web (128) about the peripheral edge (131), and a peripheral flange (130) extending outwardly from the side wall (129), and wherein the peripheral flange (130) is sealed to the vehicle component (60) and forms a watertight joint between the vehicle component and the base member (76) , and wherein:
the central web (128) preferably defines an inner side (135), and preferably includes:
a layer of reflective material (77) disposed on the inner side (135) of the central web (128).

## Patentansprüche

1. Licht-Baugruppe für Fahrzeuge, umfassend:
ein Fahrzeugbauteil (60), welches ausgelegt ist, einen Teil eines Kraftfahrzeugs zu bilden;
ein äußeres Element, welches einander gegenüberliegende innere und äußere Oberflächen definiert, wobei das äußere Element eine Platte aus Material (80) umfasst, welches einen ersten Bereich (81) aufweist, welcher wenigstens einen erheblichen Teil von Licht, welches auf die Platte (80) durch die Platte (80) einfällt, überträgt, und einen zweiten Bereich, welcher von einem Licht-blockierenden Material (78) bedeckt ist, welches im Wesentlichen weniger Licht im Verhältnis zu dem ersten Bereich (81) überträgt derart, dass der erste und zweite Bereich zusammen ein vorbestimmtes Muster definieren;
einen Lichtleiter (86), welcher angrenzend an die innere Oberfläche des äußeren Elements angeordnet ist, wobei der Lichtleiter (86) einen Licht-empfangenden Teil definiert, wobei der Lichtleiter (86) aus einem Licht-übertragenden Material besteht, welches intern einen beträchtlichen Teil des in den Lichtleiter (86) an dem Licht-aufnehmenden Teil eingeführten Lichts reflektiert, wobei der Lichtleiter (86) einen Körperbereich und einen integral gebildeten ersten Anschluss (92, 93, 101, 102) beinhaltet;
eine Lichtquelle (85), welche mechanisch mit dem Lichtleiter (86) angrenzend an den Licht-aufnehmenden Teil verbunden ist, wobei die Lichtquelle (85) einen elektrisch leitenden Schaltkreis (112, 112A) und wenigstens eine LED (114, 114A), welche mit dem Schaltkreis (112) verbunden ist, beinhaltet, wobei die Lichtquelle (85) weiter einen thermoplastischen Polymerkörper (96) beinhaltet, welcher die eine LED (114, 114A) und wenigstens einen beträchtlichen Teil des Schaltkreises (112, 112A) einhüllt, wobei der thermoplastische Polymerkörper (96) der Lichtquelle (85) einen integral gebildeten zweiten Anschluss (98, 99, 100) beinhaltet, welcher in den ersten Anschluss (92, 93, 101, 102) eingreift, und mechanisch den Lichtleiter (86) und die Lichtquelle (85) miteinander verbindet;
ein Grundelement (76), welches an dem äußeren Element befestigt ist, um damit einen wasserdichten Hohlraum (133) zu definieren, und wobei der Lichtleiter (86) und die Lichtquelle (85) innerhalb des wasserdichten Hohlraums (133) angeordnet sind;
wobei der Lichtleiter (86) als eine Platte gebildet ist; und
wobei die Lichtquelle (85) und der Lichtleiter (86) dieselbe Dicke aufweisen.

2. Licht-Baugruppe nach Anspruch 1, wobei:
das äußere Element eine Platte aus Polymermaterial umfasst, welche eine im Wesentlichen gleichförmige Dicke von 1,0 - 2,0 Millimeter aufweist.

3. Licht-Baugruppe nach Anspruch 1 oder 2, wobei:
ein ausgewählter des ersten (92, 93, 101, 102) und zweiten (98, 99, 100) Anschlusses einen Vorsprung umfasst, und der andere des ersten (92, 93, 101, 102) und zweiten (98, 99, 100) Anschlusses eine Vertiefung umfasst, und wobei der Vorsprung in der Vertiefung aufgenommen wird, wobei:
der Vorsprung bevorzugt T-förmig ist.

4. Licht-Baugruppe nach einem der vorhergehenden Ansprüche, wobei:
das Fahrzeugbauteil (60) einen planaren bzw. ebenen Bahnteil beinhaltet, welcher eine Öffnung (66) dadurch umfasst, und wobei:
das äußere Element sich durch die Öffnung erstreckt.

5. Licht-Baugruppe nach einem der vorhergehenden Ansprüche, wobei:
das Grundelement (76) eine mittlere Bahn (128) umfasst, welche eine periphere Kante (131) aufweist, und eine aufrechte Seitenwand (129), welche sich im Verhältnis zu der mittleren Bahn (128) quer um die periphere Kante (131) erstreckt, und einen peripheren Flansch (130), welcher sich von der Seitenwand (129) nach außen erstreckt, und wobei der periphere Flansch (130) an das Fahrzeugbauteil (60) gesiegelt ist und eine wasserdichte Verbindungsstelle zwischen dem Fahrzeugbauteil und dem Grundelement (76) bildet, und wobei:
die mittlere Bahn (128) bevorzugt eine Innenseite (135) definiert, und bevorzugt beinhaltet:
eine Schicht aus reflektierendem Material (77), welches an der Innenseite (135) der mittleren Bahn (128) angeordnet ist.

## Revendications

1. Assemblage formant lampe pour véhicules, comprenant:
un composant de véhicule (60) configuré pour former une portion d'un véhicule à moteur;
un élément extérieur définissant des surfaces intérieure et extérieure opposées, l'élément extérieur comprenant une feuille de matériau (80) ayant une première aire (81) qui transmet au moins une portion substantielle de la lumière incidente sur la feuille (80) à travers la feuille (80), et une seconde aire couverte par un matériau (78) bloquant la lumière qui transmet sensiblement moins de lumière par rapport à la première aire (81), de sorte que la première et la seconde aire définissent ensemble un motif prédéterminé;
un guide de lumière (86) disposé adjacent à la surface intérieure de l'élément extérieur, le guide de lumière (86) définissant une portion de réception de lumière, dans lequel le guide de lumière (86) est réalisé en un matériau transmettant la lumière qui réfléchit de manière interne une portion substantielle de la lumière introduite dans le guide de lumière (86) au niveau de la portion de réception de lumière, le guide de lumière (86) incluant une portion de corps et un premier connecteur (92, 93, 101, 102) formé intégralement;
une source de lumière (85) connectée mécaniquement au guide de lumière (86) de manière adjacente à la portion de réception de lumière, la source de lumière (85) incluant un circuit électriquement conducteur (112, 112A) et au moins une diode électroluminescente (114, 114A) connectée au circuit (112), la source de lumière (85) incluant en outre un corps en polymère thermoplastique (96) qui encapsule ladite diode électroluminescente (114, 114A) et au moins une portion substantielle du circuit (112, 112A), le corps en polymère thermoplastique (96) de la source de lumière (85) inclut un second connecteur (98, 99, 100) intégralement formé qui engage le premier connecteur (92, 93, 101, 102) et qui interconnecte mécaniquement le guide de lumière (86) et la source de lumière (85);
un élément de base (76) fixé sur l'élément extérieur pour définir avec celui-ci une cavité étanche à l'eau (133), et dans lequel le guide de lumière (86) et la source de lumière (85) sont disposés dans la cavité étanche à l'eau (133);
dans lequel le guide de lumière (86) est formé comme une feuille et
dans lequel la source de lumière (85) et le guide de lumière (86) ont la même épaisseur.

2. Assemblage formant lampe selon la revendication 1, dans lequel:
l'élément extérieur comprend une feuille de matériau polymère ayant une épaisseur sensiblement uniforme de 1,0 à 2,0 mm.

3. Assemblage formant lampe selon la revendication 1 ou 2, dans lequel:
un connecteur sélectionné parmi le premier (92, 93, 101, 102) et le second (98, 99, 100) connecteur comprend une projection, et l'autre connecteur parmi le premier (92, 93, 101, 102) et le second connecteur (98, 99, 100) comprend un creux, et dans lequel la projection est reçue dans le creux, et dans lequel :
la projection est de préférence en forme de T.

4. Assemblage formant lampe selon l'une des revendications précédentes, dans lequel:
le composant de véhicule (60) inclut une portion en nappe plane ayant une ouverture qui la traverse (66), et dans lequel:
l'élément extérieur s'étend à travers ladite ouverture.

5. Assemblage formant lampe selon l'une des revendications précédentes, dans lequel:
l'élément de base (76) comprend une nappe centrale (128) ayant une bordure périphérique (131), et une paroi latérale dressée (129) s'étendant transversalement par rapport à la nappe centrale (128) autour de la bordure périphérique (131), et une bride périphérique (130) s'étendant vers l'extérieur depuis la paroi latérale (129), et dans lequel la bride périphérique (130) est scellée sur le composant de véhicule (60) et forme un joint étanche à l'eau entre le composant de véhicule et l'élément de base (76), et dans lequel:
la nappe centrale (128) définit de préférence un côté intérieur (135), et inclut de préférence:
une couche de matériau réfléchissant (77) disposée sur le côté intérieur (135) de la nappe centrale (128).
